# EUROPEAN PATENT APPLICATION

(11) **EP 4 787 041 A1**
(43) Date of publication of application: **05.08.2026**
(21) Application number: 26154694.9
(22) Date of filing: 28.01.2026
(51) Int. Cl.: G02B 7/02, G01N 21/64, G01N 21/25, G02B 27/09

(54) **LENS MOUNT AND LIGHT ENGINE FOR FLUORESCENCE APPLICATIONS COMPRISING THE SAME**

(30) Priority: 30.01.2025 LU 103530
(71) Applicant: Stratec SE, 75217 Birkenfeld (DE)
(72) Inventor: Metz, Christoph, 75217 Birkenfeld (DE); Denk, Hanna, 75217 Birkenfeld (DE); Quitschke, Lisa-Marie, 75217 Birkenfeld (DE); Retzlaff, Rüdiger, 75217 Birkenfeld (DE); Ziegler, Johannes, 75217 Birkenfeld (DE); Ottenstein, Timo, 75217 Birkenfeld (DE); Trump, Martin, 75217 Birkenfeld (DE)
(74) Representative: Tegethoff, Sebastian

(57) **Abstract**

The present disclosure describes a lens mount which is a circular ring (56) which surrounds a lens (7) arranged in the circular ring (56), wherein the circular ring (56) comprises a torus-shaped outer contour (60) and a cylindrical inner contour with different cylindrical inner diameter, wherein the inner contour comprises a plane locating surface (63) at one inner end having a smaller diameter than the lens (7) which is arranged inside the circular ring (56) in contact with the plane locating surface (63), and a seat for the lens mount, which is the circular ring (56), comprising two partial boreholes (54) with facing openings towards another, wherein the boreholes are connected by a channel (55) in a chassis. The present disclosure also describes a light engine (1) for providing light with multiple wavelengths in fluorescence applications, comprising a plurality of light sources (10) and comprising a lens mount as described above, a PCB (11) for accommodating a light source (10) for emitting a light beam, a lamp housing (12) arranged on the PCB (11) comprising first beam shaping optical elements for the emitted light beam, and a filter (15) for adjusting each of the emitted light beams to a desired wavelength; a chassis (5) for receiving each of the plurality of light sources (10); beam splitters arranged in light beam axes downstream of each of the plurality of light sources (10); beam shaping optical elements which are arranged in the light paths of the plurality of light sources for coupling the emitted light beams into a single optical output (20) emitting a multi-wavelength light beam, and an optical compartment that is sealed against external dust and debris.

## Description

### Field of the Disclosure

The present disclosure relates to a modular assembly providing a high-power light source that allows the flexible configuration of spectral channels ideally tailored to the need of fluorescence measurement techniques used in diagnostic devices.

### Brief description of the related art

Automated analyser systems for use in clinical diagnostics and life sciences are produced by a number of companies. For example, STRATEC^{®} SE, Birkenfeld, Germany, produces a number of devices for specimen handling and detection for use in automated analyser systems and other laboratory instrumentation.

Fluorescence is used for diagnostic purposes in automated analyzer systems for imaging. A light source emits light which is absorbed by a substance. Fluorescence is the result of an absorbed photon from the light source by an orbital electron in a molecule of the substance and exciting it to a higher energy level. The electron returns to its former energy level by losing energy, emitting another photon of a different frequency, which can be observed as a fluorescent glow.

Appropriate light sources are required for applications using fluorescence. Multiple wavelengths are needed which can be used separately but preferably within the same instrument. The distribution of beam angles and intensity is influenced by the optical design of a light engine and becomes more difficult with a larger number of required channels. A homogenous distribution of beam angles is to be provided to ensure homogenous illumination for different applications including darkfield setups for instance.

The publication of Schymik and colleagues (Phys. Rev. Applied 16, 034013, 2021) reports on the trapping of single Rb atoms in tunable arrays of optical tweezers in a cryogenic environment at approximately 4 K. The publication describes the design and construction of the experimental apparatus, based on a custom-made, UHV compatible, closed-cycle cryostat with optical access. It is demonstrated the trapping of single atoms in cryogenic arrays of optical tweezers, with lifetimes in excess of s, despite the fact that the vacuum system has not been baked out. These results open the way to large arrays of single atoms with extended coherence, for applications in large-scale quantum simulation of many-body systems, and more generally in quantum science and technology.

The publication of Whiteley and colleagues (Biomed Opt. Express, 2023, 14(6), 2565-2575) teaches a targeted imaging system that has been developed for applications requiring recording from stationary samples at high spatiotemporal resolutions. It works by illuminating regions of interest in rapid sequence, and recording the signal from the whole field of view onto a single photodetector. It can be implemented at low cost on an existing microscope without compromising existing functionality. The system is characterized in terms of speed, spatial resolution, and tissue penetration depth, before being used to record individual action potentials from ASAP-3 expressing neurons in an *ex vivo* mouse brain slice preparation.

Published U.S. patent application US 2021/333532 A1 discloses a light source apparatus for providing an adjustable number of wavelength channels. The light source apparatus comprises at least a first plurality of LED modules, each LED module comprising an LED, a housing which at least partially encloses the LED, and a light director attachable to said housing for directing light emitted by the LED. The first plurality of LED modules are attached to a support structure in a first arrangement via means. In the first arrangement, light emitted by each LED of the first plurality of attachment LEDs is directed along a first optical axis. At least one LED module of the first plurality of LED modules is a removable LED module, and the attachment means is configured to allow the removal and re-attachment of the removable LED module to and from the first arrangement. The light source apparatus further comprises a plurality of driver PCBs and a controller PCB, each driver PCB of the plurality of driver PCBs being coupled to the controller PCB, and each LED module of the first plurality of LED modules is coupled to a first driver PCB of the plurality of driver PCBs. The controller PCB is configured to provide control signals to each of the driver PCBs, and each driver PCB is configured to provide drive signals to any LED module coupled with it. It is disadvantageous that the removal and re-attachment of the disclosed modules is related to tolerances between the single modules which sum-up from module to module which are attached. Such tolerances are problematic with reference for the adjustment of angles of dichroids meaning that the light beam may vary with respect to a central light axis passing through a beam splitter or other optical element. Correcting said tolerances is related to a time-consuming and complex arrangement for correction deviations.

Thus, there is a need for a light source providing an easy and efficient setup for a homogenous irradiance in the sample plane and a homogenous distribution of ray angles.

### Summary of the Disclosure

The present disclosure provides a system for a lens mount, comprising a lens mount which is a circular ring which surrounds a lens arranged in the circular ring, wherein the circular ring comprises a torus-shaped outer contour and a cylindrical inner contour with different cylindrical inner diameter, wherein the inner contour comprises a plane locating surface at one inner end having a smaller diameter than the lens which is arranged inside the circular ring in contact with the plane locating surface, and a seat for the lens mount which is the circular ring, comprising two partial boreholes with facing openings towards another, wherein the boreholes are connected by a channel.

The system comprises in an embodiment radius of torus-shaped outer contour of the circular ring corresponds to the radius of the partial borehole.

Another aspect of the system for the lens mount according to the present disclosure relates to the depth of the channel connecting the partial boreholes which corresponds to the material thickness of the circular ring.

It is further intended that the lens is glued or clamped into the circular ring.

Another object of the present disclosure is a light engine for providing light with multiple wavelengths in fluorescence applications, comprising
- a chassis for receiving a plurality of light housings comprising a PCB for accommodating a light source for emitting a light beam, a lamp housing arranged on the PCB comprising first beam shaping optical elements for the emitted light beam, and a filter for adjusting each of the emitted light beams to a desired wavelength which are mounted and positioned in the chassis;
- beam splitters arranged in light beam axes downstream of each of the plurality of light housings;
- at least one lens mount according to any one of claims 1 to 4 arranged in at least one light beam path emitted from at least one light housing of the plurality of light housings;
- an optical compartment that is sealed against external dust and debris; and
- an optical output.

It is intended that the PCB of a light housing comprises a copper circuit board for improving the thermal management.

The light housing comprises in an embodiment a joint between the light source on the PCB, wherein the lamp housing is sealed for avoiding leakage of spectrally unfiltered light.

It is envisaged that the PCB of a light housing comprises in an embodiment a memory chip for storing and reading LED data and in other embodiments at least one temperature sensor and /or a light power measuring device for detecting the power of filtered light.

In an embodiment of the light engine, it is intended that the optical output comprises an optical element, comprising a housing which is connected at an end for entry of the light beam to a base plate and at the end where the light beam leaves the optical element through an aspherical lens arranged in an aspherical lens mount, the optical element comprising a centrally arranged glass rod which is arranged with its longitudinal extension in the axis of the light beam, wherein the glass rod is fixed with a first end in an opening of the base plate and with the opposite second end in a mount, wherein the mount is arranged form-fitting in the housing so that it can move longitudinal in the housing.

It is envisaged that the chassis of a light engine comprises a temperature sensor and a controller for keeping the temperature of the light engine in a desired range by Peltier elements, heat pipes, water cooling, and/or a fan.

Another aspect of the present disclosure relates to a light engine comprising a colour sensor for monitoring the output spectrum of the emitted multi-wavelength light beam.

It is further intended that third optical elements for partially outcoupling light towards a temperature stabilized light power measuring device for keeping the output power of the light engine constant over time and varying environmental conditions.

The beam splitters of a light engine according to the present disclosure comprise dichroic mirrors in an embodiment.

The light engine comprises in an embodiment a light power measuring element for an external light source.

It is also intended that the light engine comprises in an embodiment parallel powered metal-oxide-semiconductor field-effect transistors (MOSFET) for switching between different wavelength channels.

Another embodiment relates to a light engine comprising a shunt field-effector transistor for reducing switching times.

Another object of the present disclosure relates to a use of a light engine as described above in applications measuring fluorescence.

The foregoing summary is not intended to summarize each potential embodiment or every aspect of the present disclosure.

### Summary of the Figures

The disclosure will be described based on figures. It will be understood that the embodiments and aspects of the disclosure described in the figures are only examples and do not limit the protective scope of the claims in any way. The disclosure is defined by the claims and their equivalents. It will be understood that features of one aspect or embodiment of the disclosure can be combined with a feature of a different aspect or aspects of other embodiments of the disclosure, in which:
FIG. 1 shows a perspective view onto a modular assembled light engine 1 without top cover and cooling section.
FIG. 2 shows in its left part a perspective overview of a single light source comprising a LED PCB and a lamp housing, and in its right part a sectional view through a light source.
FIG. 3 shows a light source as shown in FIG. 2 which is mounted to chassis of the light engine 1 by a clamp.
FIG. 4 shows the fixation of light source to the chassis in more detail.
FIG. 5 shows a mounted homogenizer with aspherical lens.
FIG. 6 shows a homogenizer assembly mounted to a chassis.
FIG. 7 shows mounted lenses fixed in the light engine chassis.
FIG. 8 shows a sectional view through a lens mount.

### Detailed Description of the Disclosure and the Figures

The technical problem is solved by the independent claims. The dependent claims cover further specific embodiments of the disclosure.

The present disclosure relates to a modular assembly providing a high-power light source that allows the flexible configuration of spectral channels ideally tailored to the need of fluorescence measurement techniques used in diagnostic devices. The mechanical design concept utilizes the nowadays available high precision of machining and avoids time consuming adjustment during production as much as possible.

The mechanical design of the light housing is based on a generic mount, housing the collimation optical elements as well as the excitation filter. The chassis is manufactured with high precision, and the parts (lamp housings, additional lenses, and dichroic filters) only need to be inserted, eliminating the need for time-consuming adjustments. Furthermore, the modular assembly according to the present disclosure uses a method for mounting lenses in a simple to manufacture convex lens mount that is occupied in milled half cylinders inside of the chassis. A key performance parameter of a light source used in diagnostic instruments is the stability of the optical output power, especially over temperature. The modular assembly according to the present disclosure reaches a high stability of the optical output power by direct sensing with a light sensitive device that is stabilized to a pre-defined temperature. In addition, the modular assembly allows to adapt the optical output to different optical paths subsequent to the light source, as e.g. projective optics or fibres.

The lenses are attached using a ring with a curved outer contour. The outer contour is not cylindrical. The cross-section/diameter is not constant over the length of the ring. The outer contour of the ring resembles a torus. The mount is aligned in a device using a milled contour (two partial holes on the outside and a groove in the middle) and the corresponding curved, torus-like outer contour of the ring. Due to the integrated design of the light engine, the lens mount can be positioned directly in the light engine without additional adapter components.

In addition, the lens is clamped or glued in the mount for its fixation. The lens mount has an inner stop surface for the lens. The lens is centered via the cylindrical surface. The lens is chamfered between the cylindrical surface and the flat surface to ensure flat contact and prevent damage to the lens. The cylindrical inner surface of the ring for centering the lens is interrupted by a groove. The groove serves as an adhesive gap and facilitates the application of the adhesive.

The electronics of the modular assembly comprise IMS (insulated metal substrate) copper PCBs (printed circuit board) which are better suited for LED PCBs in fluorescent applications because of their 'faster' thermal behavior than aluminum PCBs. Ceramic substrate-based LEDs are also envisaged. The LED chip arrangement(s) and layout on the LED PCB is optimized for high luminance. A memory chip is comprised for tracking, storing and reading individual LED parameters (LED type, peak wavelength, thermal data, power, maximal recorded temperature on the PCB, LED on time) and thus enables an 'intelligent' LED board. A temperature sensor(s) is arranged near the LEDs for model-based power output stabilization. Parallel-biased LED modules are comprised for fast channel switching.

All LEDs of an array are connected in series for an increased homogeneity. A uniform concept of arranging a temperature sensor on each PCB with a memory for each LED enables a modular design of a light-emitting modular assembly.

Current and voltage of the LEDs are monitored for performance and status monitoring. A continuous or pulse modulation of the LED current is intended as well as temperature stabilization of the housing by preheating, cooling, an accelerated ramp-up of the instrument for a higher accuracy/precision during operation using for instance Peltier elements, heat pipes, water cooling, fan. The matting on optically effective surfaces, on a sphere in front of the homogenizer is intended for example to decouple a feedback signal

The modular assembly is based on a redundant optical power monitoring and control without beam splitter but by scattered light measurement. An optical power measurement serves to stabilize the output power (closed loop). A heated sensor board is used for ambient temperature independent measurement results. The output spectrum is monitored using a color sensor.

The thermal connection between LED modules and heat sink is optimized by using for instance a heat-conducting paste, defined contact pressure, good surface quality of the back of the circuit board and block in the chassis, solid block in the chassis to which the circuit board is attached. A parallel individual control of the LED chips in an array is enabled to adjust homogeneity in the sample plane. A third photodiode is used for an external feedback channel.

The optics of a modular assembly according to the present disclosure comprise the optimization of the homogeneity of the illumination in the sample plane and alignment strategies by a monolithic construction of the entire device. The optical design comprises a relay system to match the exit pupil of the lamp housing to the input pupil of the light output. This extends the length of the optical paths to integrate additional optical elements for combining different spectral channels into one output.

In an alternative optical design, a Köhler arrangement (microscope illumination) is intended. The reduction of autofluorescence by using fused silica for instance is intended over a large spectral range.

A sealing between LED and lamp housing including the filter is intended to avoid unfiltered light reaching the output of the light engine.

Light bulb, gas discharge, fluorescent lamp, and all types of lasers are envisaged for taking into account laser diodes or all other light sources. The output spectrum is monitored using a color sensor or a compact spectrometer in the light engine. An alternative solution relates to a multi-array lens which is arranged directly in front of the LED chips to couple more light into the beam path for beam shaping A multiband pass filter is arranged directly on the LED module TIR optics instead of collimating lens. LED chips are arranged more freely in space like on a disco ball, i.e. not on a flat chip plane to use the available space.

Mechanically, the modular assembly according to the present disclosure comprises lens holder with curved mounts which are located in round milling contours (milling cutter diameter). Each wavelength is created by a separated lamp house representing a reusable basic module. The whole modular assembly is provided in a dust- and gas-tight sealing of the optical installation space. Clamping of the LED boards is arranged at the heat sink

The holder of the homogenizer comprises a tolerance compensation with respect to a linear expansion. A compensation of systematic tilt angle tolerances, in particular for dichroids is provided by an appropriate adjustment of the machining tools (milling cutters) on the contact surfaces. Systematic tilt angle tolerances (especially with dichroids) are compensated by appropriate positioning of the processing tools (milling cutters) on the contact surfaces. The use of low outgassing adhesives suppresses long-term changes in the device performance LED modules are provided with or without protective cover glass or encapsulation against a device atmosphere.

It is intended to use artificial intelligence for KI für monitoring and reporting of process data. Trigger signal inputs are used to shorten process times. These trigger signals initiate specific actions. For example, when the microcontroller reads this signal, it first acts on this and initiates the predefined action like controlling the brightness of the LED based on the user input or the surrounding environmental condition. That allows real time adjustments without delay and hence minimizes the time and increases the efficiency. The possible trigger inputs can be photosensor voltage or UART (universal asynchronous receiver-transmitter) communication.

Bleaching is avoided by reducing dead times with respect to LED switch-on times in the process. An operating parameter memory is provided for easy installation in the field. Brightness stabilization is achieved by software-support. A feedback control loop uses the photosensor value as a feedback to the microcontroller to read the current brightness. Error detection and correction: The software monitors the current brightness and correct it if its deviated from the required brightness by adjusting the control signals for error detection and correction. Temperature compensation is achieved by the system monitoring the temperature and correcting the control signals for the betterment.

The modular assembly according to the present disclosure can easily be adapted to different applications with respect to wavelengths and light output comprising intensity, angle spectrum, geometric shapes of the output by for instance a round fiber or a rectangular homogenizer. The assembly provides a constant light output, using multiple control features such as storage of LED specific data on each LED board, temperature sensors close to each LED Board and an optical power and wavelength control at the output.

The design takes especially care of the output homogeneity, not only regarding the light power but also the outcoming ray angles, to ensure optimal homogeneity independent of the following optics.

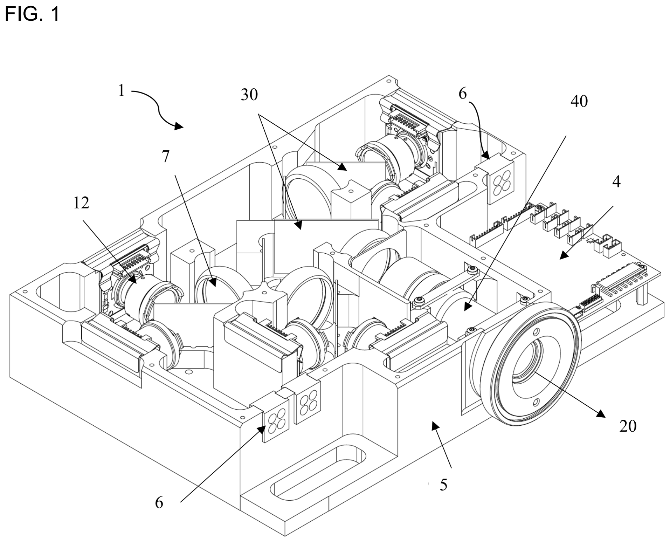

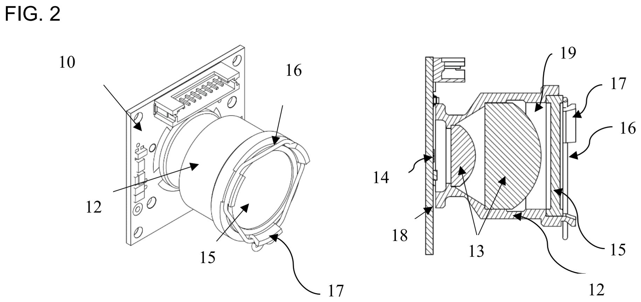

FIG. 1 shows a perspective view onto a modular assembled light engine a1 without top cover according to the present disclosure. The chassis 5 comprises six light sources 10 (cf. FIG. 2) which are brought together at a single common light output 20. Dichroic mirrors 30 are arranged in the light beam axis so that the light beam coming from each light source either passes the dichroic mirror 30 or is reflected by the respective dichroic mirrors so that the light beams coming from all light sources 10 are coupled into homogenizer 40.

Chassis 5 further comprises lenses 7 for creating an intermediate image which will ultimately project the LED array into mounted homogenizer 40 comprising glass rod 40. Intermediate imaging is important to prevent the beam path from becoming too large. Perfect collimation is not possible here, and the angles of the light beams would otherwise lead to an excessively large beam diameter.

At the dichroic mirrors certain wavelengths are reflected and others transmitted. Thus, the six channels can be merged. The homogenizer at the end of the optical path reduces inhomogeneities of the LED array and adjusts the output signal to the size of the area to be illuminated. The area to be illuminated is determined by the application.

Cable bushings 6 are provided for the connecting cables (not shown) to each light source 10 (cf. FIG. 2) to a main PCBA (printed circuit board assembly) which is provided for controlling the members of the light engine 1.

FIG. 2 shows in its left part a perspective overview of a single light source 10, and in its right part a sectional view through a light source 10. A LED PCB 11 serves as a basis plate for the light source 10. A lamp housing 12 is mounted to one side of the LED PCB 11. Lamp housing 12 comprises lenses 13 for collimation of the light excited from a LED 14 which is arranged centrally behind the circular lamp housing 12 on LED PCB 11.

Lamp housing 12 is closed on the end opposite to the end which is mounted to the LED PCB 11 with filter 15 which is fixed by spring 16 engaging in hooks 17. An adhesive 18 can be used for fixation of lamp housing 12 to LE PCB 11. Adhesive 18 will also serve for sealing of the inner space 19 of lamp housing 12 so that light will only leave lamp housing 12 through filter 15.

A light source 10 - as shown in FIG. 2 - can be regarded as an element which can be used for as many wavelength as required in the light engine. Each filter 15 can be used for adjusting the emitted wavelength of the respective light source 10.

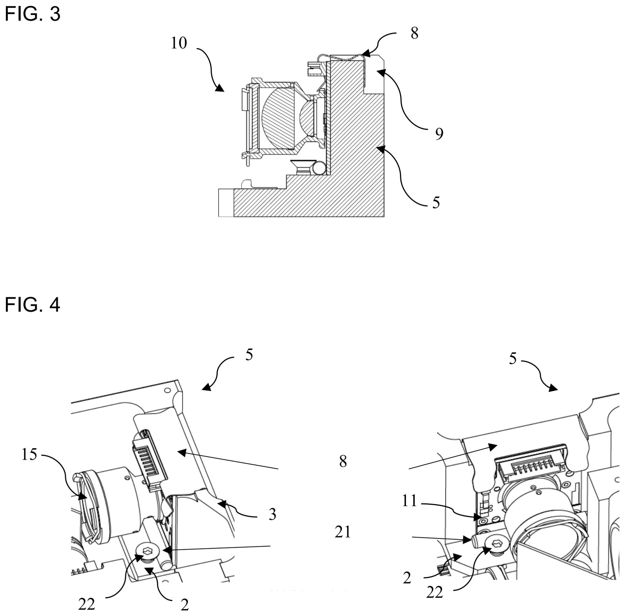

FIG. 3 shows a light source 10 as shown in FIG. 2 which is mounted to chassis 5 of the light engine 1 by a clamp 8. Chassis 5 may provide a recess 9 for accommodating clamp 8 which prevents a sidewise movement of clamp 8. The position of light source 10 is thus sufficiently determined. It is an advantage that light sources 10 can be mounted externally and simply adjusted to the required wavelength by mounting the appropriate filter 15, while the fixation to the chassis 5 is easily done with clamp 8. In addition, the light housing (lens) is aligned with the LED (in an external tool) to achieve the desired homogeneity and intensity. This adjustment avoids manufacturing tolerances and other complicated adjustments in the module.

FIG. 4 shows the fixation of light source 10 to chassis 5 in more detail. LED PCB 11 is pressed by clamp 8 to the respective side wall 3 of chassis 5. Lamp housing 12 has next to LED PCB 11 a smaller diameter than next to filter 15. The resulting edge between the two different diameter is used for fixation of the lower part of LED PCB11 with a pin 21 which is fixed to the bottom plate 2 of chassis 5 with screw 22.

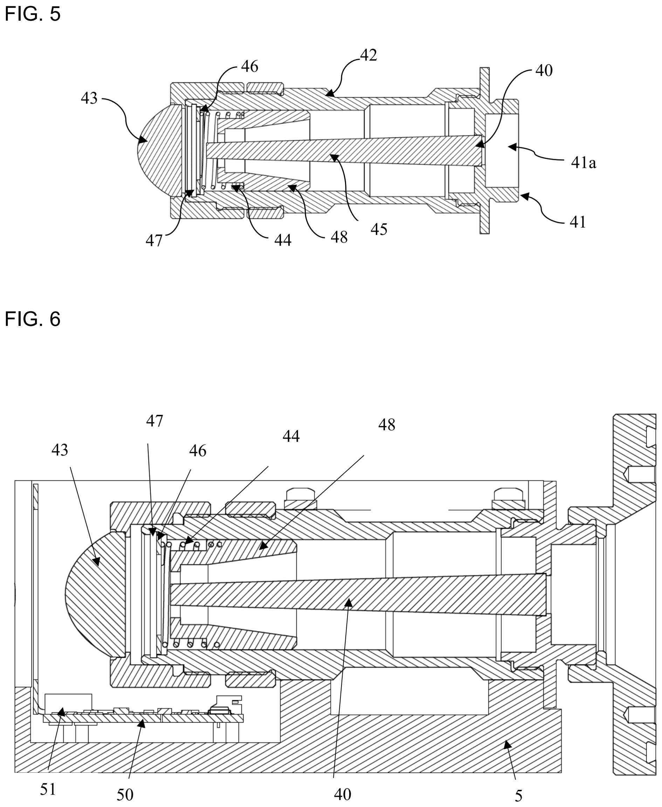

FIG. 5 shows a mounted homogenizer 40 in a sectional view. The homogenizer 40 has a cuboid shape without being limited to that shape and comprises a base plate 41 with a central opening 41a for light exit from the light engine (not shown). Cylindrical housing 42 is fixed to base plate 41. Centrally arranged in housing 42 is an glass rod 45 for transmission of the coupled light. The glass rod 45 may have a tapered shape so that its diameter decreases towards the light entry of homogenizer 40. The glass rod 45 is only fixed in the base plate 41 and in mount 48 so that the amount of decoupled light is reduced. Mount 48 is made of plastic like polyoxymethylene while base plate 41, housing 42, and mount 48, are made of anodized aluminum.

Mount 48 is pushed onto homogenizer in housing 42 which has a larger cross-section on the outside, so that the mount 48 is held in place. Mount 48 is then kept in place with spring 44 and circlip 47. Between spring 44 and circlip 47 is a washer 46 arranged. Light enters the optical homogenizer 40 through lens 43 which represents the entry point of the homogenizer 40.

FIG. 6 shows homogenizer 40 fixed in chassis 5. A sensor PCBA 50 is arranged below lens 43 and comprises sensor 51 for sensing excited light.

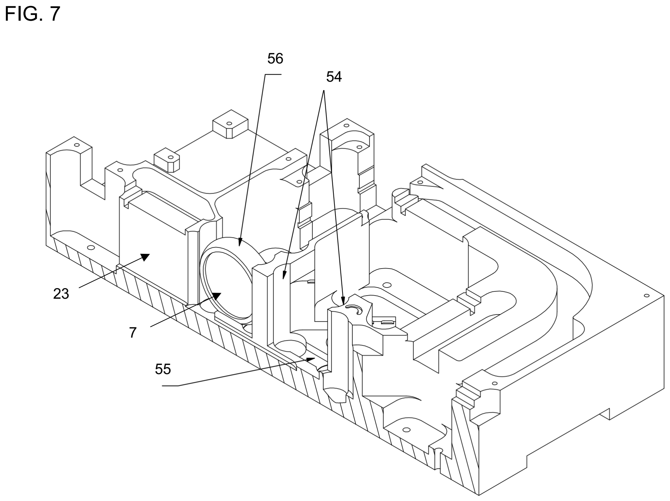

FIG. 7 shows how lens 7 is arranged in in the light engine. The lens 7 is mounted in a circular ring 56 which is accommodated in partial bores 54 (milled partial cylinders) which are connected by channel 55 in the chassis. The lenses can be prepared in the circular ring prior to simply clipping the circular ring into the partial bores 54 which are connected by a channel which makes it easy to exchange and mount appropriate lenses.

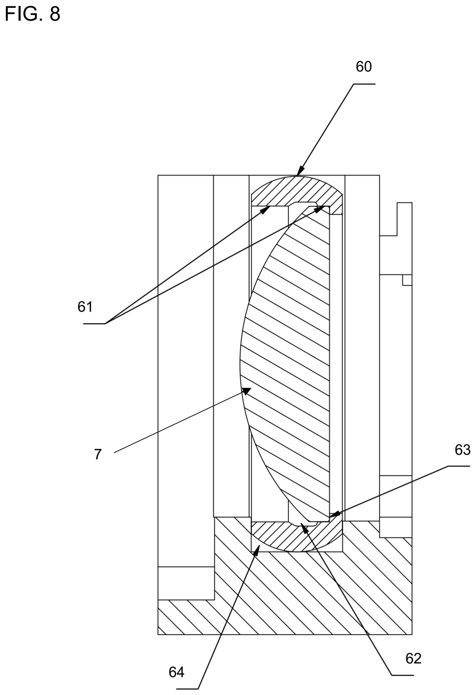

FIG. 8 shows a sectional view through a lens mount. The circular ring 56 (cf. FIG. 7) comprises a torus-shape outer contour 60 which is faced by the cylindrical inner contour having different sections with different inner diameters. A glue nut 62 is flanked by outer surfaces 61 for centering of lens 7. Support surfaces 63 which are plane surfaces hold lens 7 in the circular ring 56 of the lens mount which rests in channel 64 between the partial bores 54 (cf. FIG. 7).

The advantage of a modular assembly according to the present disclosure relates to its modular setup, allowing to adapt only the part necessary for the respective application, for example the wavelength, number of channels, output shape, focal length of lenses, without changing anything else.

Alternative approaches relate to
- Temperature stabilization: preheating, cooling, faster ramp-up of the instrument for higher accuracy/precision in operation (Peltier elements, heat pipes, water cooling, fan...)
- Parallel individual control of the LED chips of an array for setting the homogeneity in the sample plane - LEDs with integrated automatic death certificate / e.g. photodiode on LED module / process monitoring in connection with all other components - Continuous or pulse modulation of LED current - Third photodiode for external feedback channel e.g. photodiode on LED module /process monitoring in conjunction with all other components
- Continuous or pulse modulation of LED current
- Third photodiode for external feedback channel
- Matting on optically effective surfaces (on a sphere in front of the homogenizer, for example) for coupling out a feedback signal. - Alternative optical setups: Köhler arrangement (microscope illumination), not limited to this
- Alternative methods for beam superimposition of the individual channels

The foregoing description of preferred and other embodiments is not intended to limit or restrict the scope or applicability of the inventive concepts conceived of by the Applicants. It will be appreciated with the benefit of the present disclosure that features described above in accordance with any embodiment or aspect of the disclosed subject matter can be utilized, either alone or in combination, with any other described feature, in any other embodiment or aspect of the disclosed subject matter.

**Reference Numerals**

| | | | |
|---|---|---|---|
| 1 | light engine | 61 | outer surfaces |
| 2 | bottom plate | 62 | glue nut |
| 3 | side wall | | |
| 4 | main PCBA | | |
| 5 | chassis | | |
| 6 | cable bushing | | |
| 7 | lens | | |
| 8 | clamp | | |
| 9 | recess | | |
| 10 | light source | | |
| 11 | LED PCB | | |
| 12 | lamp housing | | |
| 13 | lens | | |
| 14 | LED | | |
| 15 | filter | | |
| 16 | spring | | |
| 17 | hook | | |
| 20 | light output | | |
| 21 | pin | | |
| 22 | screw | | |
| 23 | intermediate wall | | |
| 30 | dichroic mirror | | |
| 40 | homogenizer | | |
| 41 | base plate | | |
| 41a | central opening | | |
| 42 | housing | | |
| 43 | aspherical lens | | |
| 44 | spring | | |
| 45 | fiber | | |
| 46 | washer | | |
| 47 | circlip | | |
| 48 | mount | | |
| 50 | sensor PCBA | | |
| 51 | sensor | | |
| 52 | aspheric lens support | | |
| 53 | counter ring | | |
| 54 | partial bores | | |
| 55 | channel | | |
| 56 | circular ring | | |
| 60 | outer contour | | |

## Claims

1. A system for the fixation of a lens mount, comprising a
- lens mount which is a circular ring which surrounds a lens arranged in the circular ring, wherein the circular ring comprises a torus-shaped outer contour and a cylindrical inner contour with different cylindrical inner diameter, wherein the inner contour comprises a plane locating surface at one inner end having a smaller diameter than the lens which is arranged inside the circular ring in contact with the plane locating surface, and
- a seat for the lens mount, which is the circular ring, comprising two partial boreholes with facing openings towards another, wherein the boreholes are connected by a channel.

2. The system of claim 1, wherein the radius of torus-shaped outer contour of the circular ring corresponds to the radius of the partial borehole.

3. The system of claim 1 or claim 2, wherein the depth of the channel connecting the partial boreholes corresponds to the material thickness of the circular ring.

4. The system of any one of claims 1 to 3, wherein the lens is clamped or glued into the circular ring.

5. A light engine for providing light with multiple wavelengths in fluorescence applications, comprising
- a chassis for receiving a plurality of light housings comprising a PCB for accommodating a light source for emitting a light beam, a lamp housing arranged on the PCB comprising first beam shaping optical elements for the emitted light beam, and a filter for adjusting each of the emitted light beams to a desired wavelength, wherein the light housings are mounted and positioned in the chassis;
- beam splitters arranged in light beam axes downstream of each of the plurality of light housings;
- at least one lens mount according to any one of claims 1 to 4 arranged in at least one light beam path emitted from at least one light housing of the plurality of light housings;
- an optical compartment that is sealed against external dust and debris; and
- an optical output.

6. The light engine of claim 5, wherein the PCB of the light housing comprises a copper circuit board for improving the thermal management.

7. The light engine of claim 5 or 6, wherein the light housing comprises a joint between the light source on the PCB and the lamp housing is sealed for avoiding leakage of spectrally unfiltered light.

8. The light engine of any one of claims 5 to 7, wherein the PCB of the light housing comprises a memory chip for storing and reading LED data.

9. The light engine of any one of claims 5 to 8, wherein the PCB of the light housing comprises at least one temperature sensor

10. The light engine of any one of claims 5 to 9, wherein the PCB of the light housing comprises a light power measuring device for detecting the power of filtered light

11. The light engine of any one of claims 5 to 10, wherein the optical output comprises an optical element, comprising a housing which is connected at an end for exit of the light beam to a base plate and at the end where the light beam enters the optical element through an aspherical lens arranged in an aspherical lens mount, the optical element comprising a centrally arranged glass rod which is arranged with its longitudinal extension in the axis of the light beam, wherein the glass rod is fixed with a first end in an opening of the base plate and with the opposite second end in a mount, wherein the mount is arranged form-fitting in the housing so that it can move longitudinal in the housing.

12. The light engine of any one of claims 5 to 11, wherein the chassis comprises a temperature sensor and a controller for keeping the temperature of the light engine in a desired range by Peltier elements, heat pipes, water cooling, and/or a fan.

13. The light engine of any one of claims 5 to 12, comprising a color sensor for monitoring the output spectrum of the emitted multi-wavelength light beam.

14. The light engine of any one of claims 5 to 13, comprising third optical elements for partially outcoupling light towards a temperature stabilized light power measuring device for keeping the output power of the light engine constant over time and varying environmental conditions.

15. The light engine of any one of claims 5 to 14, wherein the beam splitters comprise dichroic mirrors.

16. The light engine of any one of claims 5 to 15, comprising a light power measuring element for an external light source.

17. The light engine of any one of claims 5 to 16, comprising parallel powered metal-oxide-semiconductor field-effect transistors (MOSFET) for switching between different wavelength channels.

18. The light engine of any one of claims 5 to 17, comprising a shunt field-effector transistor for reducing switching times.

19. The use of a light engine according to any one of claims 5 to 18 in applications measuring fluorescence.
